Europäisches Patentamt

European Patent Office

Office européen des brevets

(19)

(11) Veröffentlichungsnummer: **0 012 721**
**B1**

(12) **EUROPÄISCHE PATENTSCHRIFT**

(45) Veröffentlichungstag der Patentschrift:
04.08.82

(21) Anmeldenummer: 79810175.4

(22) Anmeldetag: 05.12.79

(51) Int. Cl.³: **G 01 R 31/14**, G 01 R 31/12,
H 02 M 7/515

(54) **Hochspannungsprüfanlage.**

(30) Priorität: 08.12.78  CH 12545/78

(43) Veröffentlichungstag der Anmeldung:
25.06.80 Patentblatt 80/13

(45) Bekanntmachung des Hinweises auf die Patenterteilung:
04.08.82 Patentblatt 82/31

(84) Benannte Vertragsstaaten:
AT BE CH DE FR GB IT NL SE

(56) Entgegenhaltungen:
CH-A-422 977
US-A-3 703 692
JOURNAL OF PHYSICS E, Scientific Instruments, Band 8, Nr. 9, 1975, London, GB, R. Miller et al.: »A variable low frequency high voltage generator using valves with fibre optic light guide control«, Seiten 748—750

(73) Patentinhaber: **Forschungskommission des SEV und VSE für Hochspannungsfragen (FKH), Gloriastrasse 35/G 77, CH-8092 Zürich (CH)**

(72) Erfinder: **Zaengl, Walter Sebastian, Prof. Dr.-Ing., Kreuzbühlstrasse 35, CH-8600 Dübendorf (CH)**
Erfinder: **Bernasconi, Felix, Dipl.-Ing., Luisenstrasse 27, CH-8005 Zürich (CH)**

(74) Vertreter: **Frauenknecht, Alois J., c/o PPS Polyvalent Patent Service AG Fohrhölzlistrasse 19, CH-5443 Niederrohrdorf (CH)**

## Hochspannungsprüfanlage

Die vorliegende Erfindung bezieht sich auf eine Anlage zur Erzeugung hoher Wechselspannungen mit einem Serienresonanzkreis, gebildet aus einer Kapazität und einer Induktivität, die vorzugsweise zu Hochspannungsprüfungen von elektrischen Isolierungen Anwendung findet.

Elektrische Isolierungen müssen mit hohen Spannungen geprüft werden, um deren Isolierfähigkeit unter Beweis zu stellen. Sämtliche Isolierungen wirken wie ein praktisch verlustfreier Kondensator. Die übliche Prüfung von Isolierungen erfolgt mit einem Hochspannungstransformator, welcher von einer variablen Spannungsquelle gespeist wird. Hochspannungstransformator und Spannungsquelle müssen dabei für die volle im wesentlichen kapazitive Leistung dimensioniert sein, wodurch ein beträchtlicher technischer Aufwand entsteht. Eine Kompensation dieser Blindleistung ist grundsätzlich möglich, wodurch der gesamte technische Aufwand jedoch nicht wesentlich reduziert wird.

Eine Kompensation der kapazitiven Leistung ist auch durch Resonanzkreise möglich. Die Einspeisung für derartige Anlagen erfolgt mit fester Frequenz, so daß zur Erzeugung von hohen Spannungen (beim Serienresonanzkreis) oder der völligen bzw. weitgehenden Kompensation der kapazitiven Blindleistung (beim Parallelresonanzkreis) kontinuierlich veränderliche Drosseln notwendig sind, die direkt als Hochspannungs-Drosseln ausgebildet sind.

Die Wechselspannungsprüfung von Isolierungen erfolgt in der Regel mit technischer Frequenz, d. h. mit 50 Hz oder 60 Hz, wozu sich sowohl die üblichen, obenerwähnten Prüftransformatoren, oder die ebenfalls vorher erwähnten Resonanzkreise eignen. Sollen jedoch andere Frequenzen verwendet werden, so müssen diese über rotierende Maschinen (Generatoren) erzeugt werden, die in Verbindung mit den Prüftransformatoren die durch internationale Regeln festgelegte sinusförmige Wellenform der Spannungen bei der notwendigen Leistung erzeugen können. Da auch noch die Spannung dieser Generatoren in weiten Bereichen kontinuierlich eingestellt werden muß, werden diese teuer und aufwendig. Sollen diese Generatoren für die Speisung der obenerwähnten Resonanzkreise verwendet werden, so wird der technische Aufwand noch größer, da dann auch noch die Frequenz (Drehzahl) der Generatoren extrem stabil sein muß, um die Resonanzfrequenz einhalten und die Spannung auf einem eingestellten Wert stabilisieren zu können. Die Erzeugung hoher Prüf-Wechselspannungen mit von Netzfrequenz abweichender Frequenz mit bekannten Methoden ist somit sehr aufwendig.

Nicht möglich ist eine Spannungsfprüfung mit technischer Frequenz (50 Hz bzw. 60 Hz) bei der Windungsprüfung von Induktivitäten, Transformatoren oder Hochspannungswandlern, bei denen ein sättigbarer Eisenkreis vorhanden ist. Die Prüfung von Isolierungen mit kleinerer oder vor allem auch höherer Frequenz als Netzfrequenz ist oftmals äußerst zweckmäßig und notwendig, um Isoliereigenschaften in Abhängigkeit von der Frequenz zu untersuchen. So z. B. können Alterungsvorgänge in festen Isolierstoffen, die durch die elektrische Beanspruchung verursacht werden, durch relativ hohe Frequenzen ($\leq 2$ kHz) stark beschleunigt werden, vor allem dann, wenn im Isolierstoff sogenannte Teilentladungen z. B. in Hohlräumen auftreten.

Der Erfindung liegt insbesondere die Aufgabe zugrunde, eine Hochspannungsprüfanlage der eingangs genannten Art zu schaffen, die die beschriebenen Nachteile des Bekannten nicht aufweist und mit der auch andere Frequenzen als Netzfrequenzen mit geringem Aufwand erzeugt werden können. Die Hochspannungsprüfanlage soll möglichst universell verwendbar sein und ein niedriges Gewicht aufweisen und leicht transportierbar sein.

Die im Anspruch 1 angegebene Erfindung weist den Vorteil auf, daß sie eine Prüfung der Isolation mit Frequenzen ermöglicht, die kleiner oder größer sind als Netzfrequenz, wobei hohe Spannungen besonders wirtschaftlich und auf kleinstem Raum erzeugt werden können.

Zur Ausnutzung des in einer Anordnung nach Anspruch 1 erzielbaren Resonanzeffektes ist eine Spannungsquelle einsetzbar, deren Frequenz innerhalb von ±5% der Resonanzfrequenz des Kreises (Serienresonanzkreis mit der zu prüfenden Isolation) einstellbar ist.

Die Einstellung der Prüfspannung kann in praxi durch eine Feinanpassung der Frequenz des Umrichters und/oder eine Phasenverschiebung von Strom und Spannung am Ausgang des Umrichters und/oder der Pulsbreite der Umrichterspannung und/oder der Amplitude der Umrichterspannung als auch durch eine Änderung der Resonanzfrequenz des Kreises bzw. Anpassung und/oder Veränderung dessen Güte durch einstellbare Widerstände realisiert werden.

Vorteilhafte Weiterbildungen der Erfindung sind in den Unteransprüchen beschrieben.

Der Vorteil der Ausführungsform gemäß Anspruch 2 liegt darin, daß die festen Induktivitätswerte eine Verwendung von kleinen, leichten und billigen Bauarten der Drosseln ermöglichen.

Durch die Ausgestaltung gemäß Anspruch 3 kann die Grob-Anpassung an den benötigten Spannungs-, Frequenz- oder Leistungsbereich erreicht werden.

Die Weiterbildung gemäß Anspruch 4 ermöglicht eine schnelle und einfache Einstellung des Induktivitätswertes und/oder der Leistung.

Der Vorteil der im Anspruch 5 angegebenen Stabkerndrossel liegt darin, daß die Stabkerndrosseln ein kleines Leistungsgewicht und somit auch geringe Verluste aufweisen. Sie erlauben hochspannungstechnisch einen günstigen Aufbau als Einzelelement sowie auch in Kaskadenschaltung. Wegen des geringen Eisenanteils erreichen die Eisenverluste erst bei relativ hohen Frequenzen die Kupferverluste, so daß die Stabkerndrosseln insbesondere für Resonanzkreise über 50 Hz geeignet sind.

Die Weiterentwicklung nach Anspruch 6 zeigt eine besonders vorteilhafte Ausführungsform der Spannungsquelle mit veränderlicher Frequenz.

Der Anspruch 7 beschreibt eine für die Hochspannungsprüfanlage zweckmäßige Umrichterschaltung, die sowohl eine stufenlos variable Frequenz bereitstellt, als auch eine stufenlose Spannungseinstellung an der zu prüfenden Isolation ermöglicht und daher vorteilhaft ist.

Die Ausgestaltung nach Anspruch 8 ermöglicht, mit preiswerten Kondensatoren parallel zur Isolation die Kapazität zu erhöhen und somit eine weitere Grob-Anpassung der Prüffrequenz zu erreichen.

Der Vorteil der Variante nach Anspruch 9 ist darin zu sehen, daß diese sehr einfach zu realisieren ist und sich die Prüfspannung besonders genau und einfach regeln läßt, weil zwischen dem Leistungsfaktor cosΦ (Phasenverschiebung zwischen Strom und Spannung) am Ausgang des Umrichters und der Hochspannung im Schwingkreis (=Prüfspannung) ein linearer Zusammenhang besteht.

Die Ausführungsform gemäß Anspruch 10 ergibt einen sehr geräuscharmen Betrieb, da keine Magnetisierungseffekte, z. B. Magnetostriktion, auf das Gehäuse direkt übertragen werden.

Die Trägerplatte nach Anspruch 11 wirkt sowohl als durchschlagfeste Isolierstoffbarriere zwischen den Wicklungen der Stabkerndrossel als auch als Dämpfungsglied für mechanische Schwingungen.

Die Ausgestaltung gemäß Anspruch 12 ergibt eine günstige Spannungsverteilung und somit eine hohe Stoß-Spannungsfestigkeit der Drossel, was insbesondere im Falle des Durchschlagens eines Prüflings zur Verhinderung von Kurzschlüssen in der Drossel notwendig ist.

Die Ausführungsform nach Anspruch 13 enthält eine vorteilhafte Konstruktion des Gehäuses der Stabkerndrossel, wobei die Membrane die Wärmedehnung des im Inneren des Gehäuses befindlichen hochwertigen, flüssigen oder gasförmigen Isolierstoffes ohne unzulässige Steigerung des Druckes ermöglicht.

Die Ausgestaltung der Wicklung nach Anspruch 14, vorzugsweise eine Lagenwicklung, mit trapezförmigem Querschnitt erlaubt einen besonders gedrängten Aufbau der Drossel und gewährleistet gute Isolationsverhältnisse durch eine den Potentialdifferenzen zwischen den beiden Wicklungen angepaßte Geometrie.

Die Ausführung nach Anspruch 15 ermöglicht eine galvanische Verbindung der Wicklungen auf dem selben Potential, so daß keine besonderen Maßnahmen zur Isolation der Verbindungsschlaufe beider Wicklungen notwendig werden und die Isolation des Stabkerns stark vereinfacht wird.

Die Weiterbildung einer Stabkerndrossel nach Anspruch 16 ist besonders bei der Realisierung von Drosseln sehr hoher Leistung vorteilhaft.

Der Erfindungsgegenstand wird im folgenden an Hand schematischer Zeichnungen näher erläutert und weitere Vorteile beschrieben. Es zeigt

Fig. 1 eine Grundschaltung des Erfindungsgegenstandes mit einer Drossel und mit einer Kapazität, die nur durch die Isolation gebildet ist,

Fig. 2 eine weitere beispielsweise Schaltung mit zwei in Serie geschalteten Drosseln und einem parallel zur geprüften Isolation geschalteten Hochspannungskondensator,

Fig. 3 eine weitere beispielsweise Ausführungsform, bei der die Induktivität aus vier Drosseln zusammengesetzt ist,

Fig. 4 normalisierte Charakteristika für die Grundschaltung nach Fig. 1,

Fig. 5 eine bevorzugte erfindungsgemäße Ausgestaltung mit einem Schwingkreisumrichter,

Fig. 6 Diagramme der Spannungen und des Stromes aus Fig. 5 zur Einstellung der Prüfspannung, nach

Fig. 6b und 6c, wobei wahlweisem Einsatz des Phasenverschiebungsverfahrens oder nach

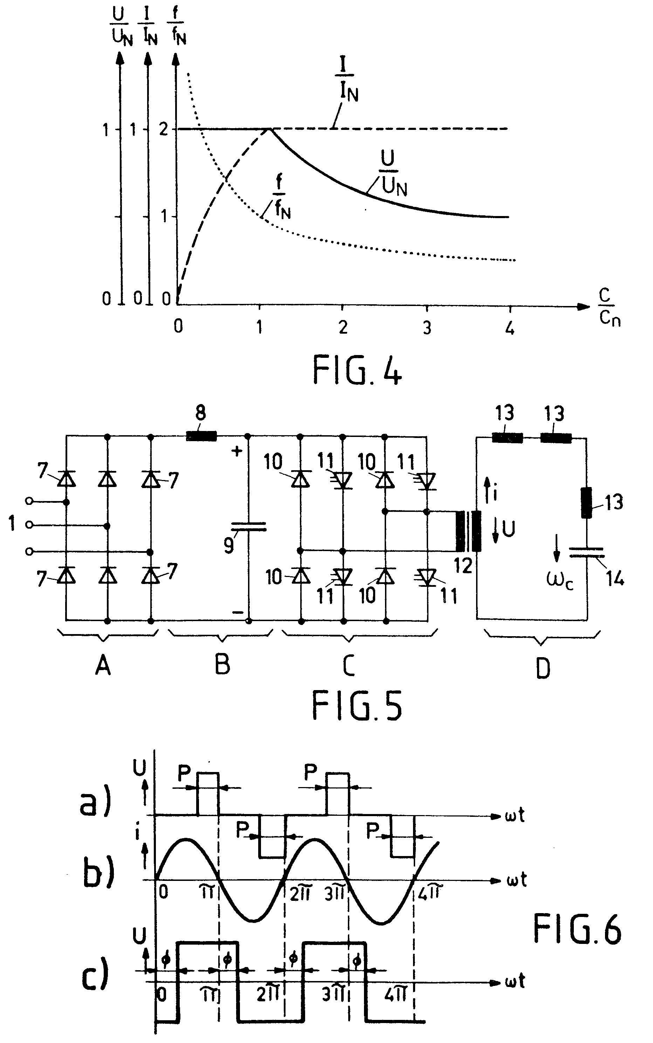

Fig. 6a und 6b bei Einsatz des Pulsbreitensteuerverfahrens,

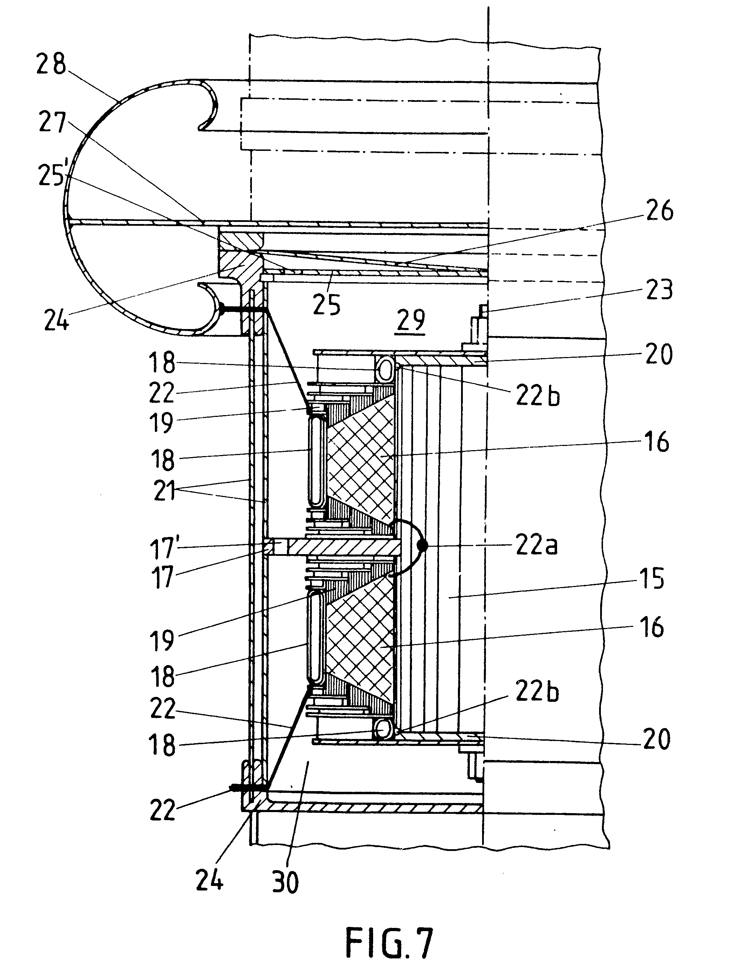

Fig. 7 einen vereinfachten, axialen Schnitt durch eine beispielsweise Ausführungsform einer Stabkerndrosselspule und

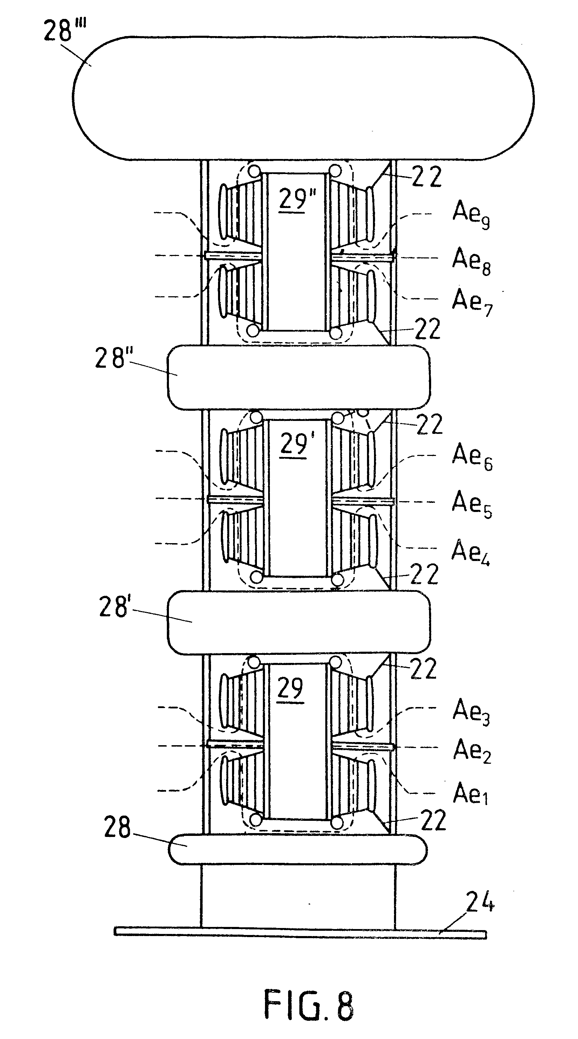

Fig. 8 einen vereinfachten Schnitt durch drei baukastenartig aufeinander gestellte Stabkerndrosseln mit darin eingezeichneten Äquipotentiallinien des resultierenden elektrischen Feldes.

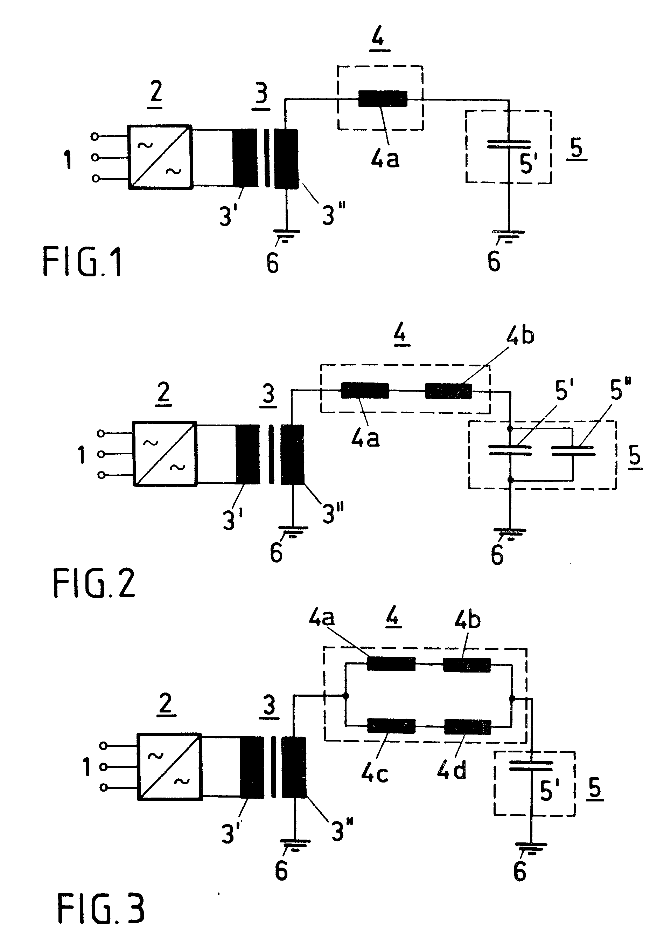

Gemäß Fig. 1 ist auf ein Netz 1 ein Umrichter 2 angeschlossen, der ein als Schwingkreisumrichter ausgebildeter Direktumrichter ist, der in der Resonanzfrequenz und mit Impulsbreitensteuerung arbeitet. Der Umrichter 2 ist mit der Primärwicklung 3' eines Transformators 3 verbunden. Ein Ende der Sekundärwicklung 3'' ist mit einem Serienresonanzkreis verbunden, der durch eine Induktivität 4 und eine Kapazität 5 gebildet ist. Die Induktivität 4 ist eine Stabkernhochspannungsdrossel 4a, und die Kapazität 5 ist durch die geprüfte Isolation 5' gebildet. Der Sekundärkreis ist an Erdungen 6 angeschlossen. Dabei fließt im Serienresonanzkreis ein Strom I, während an der Kapazität 5 eine Spannung U auftritt.

In Fig. 2 und 3 sind gleiche Teile mit denselben Bezugsziffern versehen wie in Fig. 1.

Gemäß Fig. 2 ist die Induktivität 4 durch eine Serienschaltung von zwei Hochspannungsdrosseln 4a und 4b gebildet. Parallel zu der Isolation 5' ist ein Hochspannungskondensator 5'' angeschaltet.

Die Fig. 3 zeigt eine Weiterentwicklung des Erfindungsgegenstandes. Die Induktivität 4 ist aus als Baukastenelementen ausgebildeten Hochspannungsdrosseln 4a bis 4d zusammengesetzt.

Durch stufenweise Serie- und/oder Parallelschaltung der Hochspannungsdrosseln 4a bis 4d läßt sich eine optimale Lastverteilung erzielen, so daß hierfür Bauelemente relativ niedriger Leistung und Gewichte einsetzbar sind. Außerdem ist bei Verwendung von Hochspannungsdrosseln 4a bis 4d unterschiedlicher Induktivitäten eine weitere Anpassung des Serienresonanzkreises an die zu prüfende Isolation möglich.

Die Funktionsweise und Dimensionierung der Hochspannungsprüfanlage läßt sich anhand nachfolgender Zusammenhänge näher erläutern; daraus ergibt sich auch eine ausführliche Begründung der Vorteile des Erfindungsgegenstandes.

Die an der Kapazität 5, im Resonanzfall auftretende hohe Spannung entsteht dadurch, daß die in der Kapazität 5 gespeicherte Energie gleich groß wird wie in der Induktivität 4. Die hierzu notwendige Kreisfrequenz $\omega$ bzw. Prüffrequenz f beträgt dabei:

$$\omega = 2\pi \cdot f = \frac{1}{\sqrt{LC}},$$

wobei: L = Induktivität, C = Kapazität bedeuten.

Auch bei einer nur wenig von der Prüffrequenz f abweichenden Frequenz entsteht hier eine noch wesentlich höhere Spannung als die den Serienresonanzkreis 4, 5 anregende, an der Sekundärwicklung 3″ des Transformators 3 anliegende Spannung. Diese höhere Spannung entsteht durch die im Serienresonanzkreis 4, 5 auftretende geringe Dämpfung (Güte 170 > Q > 50).

An sich kann folglich die Höhe der Spannung an der zu prüfenden Isolation durch Einstellen einer von der Kreisfrequenz $\omega$ abweichenden Frequenz am Umrichter 2 gewählt werden. In einem Ausführungsbeispiel ist jedoch hierfür als Umrichter 2 ein als Schwingkreisumrichter ausgebildeter Direktumrichter mit Impulsbreitensteuerung eingesetzt.

Dementsprechend wird die Größe der Induktivität 4 derart dimensioniert, daß sich in Verbindung mit der zu prüfenden Nennkapazität $C_N$, welche praktisch die höchste zu prüfende Kapazität C darstellt, eine tiefste Betriebs-Kreisfrequenz $\omega_N$ einstellt. Die daraus resultierende Nenn-Induktivität $L_N$ wird gemäß der nachstehenden Gleichung errechnet:

$$L_N = \frac{1}{\omega_N^2 \cdot C_N}.$$

Die Nenninduktivität $L_N$, in einer beispielsweisen Ausführungsform als gleichartige Baukastenelemente aufgebaut, kann für die nominale Spannung $U_N$, mit einer Nominalkapazität $C_N$ ausgelegt sein. — Die an der Sekundärwicklung 3″ des Transformators 3 anliegende Spannung kann vernachlässigt werden. Die Nenn-Induktivität $L_N$

muß einen Strom $I_N$ z. B. auch während eines Dauerbetriebs führen können. Dazu gilt:

$$I_N = U_N \cdot \omega_N \cdot C_N$$

Werden nur kapazitätsärmere Isolationen geprüft, die einen Wert C besitzen, so ist eine größere Frequenz f erforderlich. Diese Variation der Prüffrequenz ergibt sich unmittelbar aus den oben aufgeführten Gleichungen; durch einen Ersatz von L durch $L_N$ ergibt sich:

$$\frac{\omega}{\omega_N} = \frac{f}{f_N} = \sqrt{\frac{C_N}{C}},$$

wobei: $f_N$ = Nennfrequenz ist. Vergleiche hierzu Fig. 4.

Ist beispielsweise $C_N = 25 \cdot C$, so wird $f = 5 \cdot f_N$, also fünfmal größer als jene Frequenz $f_N$, welche bei der größten zu prüfenden Isolation notwendig ist. Die dazu verwendete Drossel $L_N$ bleibt trotz dieser Frequenzüberhöhung strommäßig stets unterhalb der zulässigen Strombelastung. Dieser Strom $I_N$ nimmt bei voller Prüfspannung den Wert

$$I = U_N \cdot \omega \cdot C$$

an, wobei er sich unter Berücksichtigung der beiden letztgenannten Gleichungen wie folgt ändert:

$$\frac{I}{I_N} = \frac{\omega\, C}{\omega_N \cdot C_N} = \sqrt{\frac{C}{C_N}}.$$

Beträgt z. B. $C_N = 25\, C$, so wird $I = \frac{I_N}{5}$.

(vgl. dazu Fig. 4).

Daraus folgt, daß auch bei relativ kapazitätsarmen Isolierungen die Drosseln strommäßig gut ausgenutzt werden.

Als besonders vorteilhaft erweist sich der Serienresonanzkreis mit variabler Frequenz auch für den Fall, daß noch wesentlich höhere Kapazitäten als $C_N$ geprüft werden sollen, wenn die nominale Spannung $U_N$ reduziert wird. Für die Drossel stellt dann lediglich der Strom $I_N$ die Belastungsgrenze dar. Da der Drosselstrom $I = U \cdot \omega \cdot C$ ist, und sich der maximal zulässige Drosselstrom aus der Bestimmungsgleichung für $I_N$ berechnen läßt, kann die Strombelastung der Drossel auch in der folgenden, normierten Form geschrieben werden, wenn man beachtet, daß die ebenfalls abgeleitete Beziehung für $\omega/\omega_N$ auch für $C > C_N$ gültig ist:

$$\frac{I}{I_N} = \frac{U}{U_N} \cdot \frac{\omega}{\omega_N} \cdot \frac{C}{C_N} = \frac{U}{U_N} \cdot \sqrt{\frac{C}{C_N}}.$$

Da stets $I = I_N$ sein kann, folgt daraus der Zusammenhang zwischen einer gegenüber der Nennspannung $U_N$ zu reduzierenden Prüfspannung $U \leq U_N$ bei zulässiger größerer Kapazität $C \geq C_N$:

$$\frac{U}{U_N} = \sqrt{\frac{C_N}{C}} \qquad \text{(vgl. hierzu Fig. 4)}$$

Für $C = 4 \cdot C_N$ muß somit die Prüfspannung U nur um die Hälfte reduziert werden. Daraus ergibt sich für den Anwender den Vorteil einer Vielzahl von Variationsmöglichkeiten auch bereits mit einer einzigen vorhandenen Drossel.

Da der Direktumrichter der Spannungsquelle 2 nur die Verluste des Serienresonanzkreises 4, 5 und des Transformators 3 decken muß, welche jedoch insgesmat sehr klein bleiben, dimensioniert man den Umrichter 2 und den Transformator 3 zweckmäßigerweise so, daß später Reserven für eventuelle Erweiterungen der Hochspannungsprüfanlage vorhanden sind. Auf einfache Weise ergibt sich eine derartige Erweiterung durch Serien- und/oder Parallelschaltung von wenigstens zwei gleichwertigen Hochspannungsdrosseln 4a bis 4d.

Ein weiterer Vorteil entsteht durch die Serienschaltung der Drosseln: Bei derselben Nennfrequenz $f_N$ bzw. $\omega_N$ kann eine Isolation mit der Kapazität $C_N/2$ mit der doppelten Spannung $2 \cdot U_N$ geprüft werden, wie sich unmittelbar aus den oben aufgeführten Gleichungen ergibt.

Bei Parallelschaltung zweier gleicher Drosseln mit den Nennwerten $L_N$, $U_N$ und $I_N$ kann eine Kapazität der Größe von $2 \cdot C_N$ mit der vollen Spannung $U_N$ wiederum mit der Frequenz $f_N$ beansprucht werden.

Wie die Variante nach Fig. 3 andeutet, lassen sich mit als Baukastenelemente aufgebauten Drosseln nahezu beliebig viele Kombinationen für eine Variation der Prüffrequenz f oder der Prüfspannung U realisieren. Hierfür eignen sich sowohl gleichartig aufgebaute Drosseln konstanter Induktivitätswerte als auch andere, beispielsweise in Wertverhältnissen von 1 : 2 und/oder 2 : 5 abgestufte Drosseln.

Die in Fig. 4 dargestellten, normierten Charakteristika, welche durch die obigen Gleichungen bereits eingehend erläutert wurden, lassen sich sinngemäß auch auf den Einsatz mehrerer Induktivitäten 4 bzw. 4a bis 4d anwenden, wenn die dabei auftretenden Spannungs- und Strombelastungen berücksichtigt werden.

Eine bevorzugte Ausgestaltung einer Hochspannungsprüfanlage mit Schwingkreisumrichter gemäß Fig. 5 besteht aus einem Gleichrichter A, einem Gleichstromzwischenkreis B, einem Wechselrichter C und einem Hochspannungsschwingkreis D. Der Gleichrichter A besteht aus Dioden 7 in Brückenschaltung und ist an das Netz 1 angeschlossen. Der Gleichstromzwischenkreis B enthält eine Drossel 8 und einen Kondensator 9. Der Wechselrichter C ist durch vier Dioden 10 und vier Thyristoren 11 mit Löscheinrichtung gebildet. Ein Anpassungstransformator 12 verbindet den Wechselrichter C mit dem Hochspannungsschwingkreis D, der in diesem Beispiel drei Drosseln 13 und eine Kapazität 14 enthält.

Der Verlauf der Spannung U am Eingang des Schwingkreises nach Fig. 5 ist aus Fig. 6a und 6c ersichtlich. Der Verlauf des Schwingstromkreises i ist in Fig. 6b dargestellt. Im Falle einer Pulsbreitensteuerung gilt die Darstellung mit variabler Pulsbreite P in Funktion des Winkels $\omega t$ nach Fig. 6a; bei einer Steuerung über die Phasenverschiebung die Darstellung nach Fig. 6c mit eingezeichnetem Phasenverschiebungswinkel $\Phi$.

Gemäß Fig. 7 besteht eine Stabkerndrossel 29 aus einem radial geblechten Stabkern 15, der zwei die Spule bildende Wicklungen 16 trägt. Benachbarte Spulenanschlüsse sind untereinander und mit dem Stabkern 16 durch eine galvanische Verbindung 22a in Kontakt. Diese beiden aus einzelnen Windungslagen aufgebauten Wicklungen 16 weisen trapezförmige Querschnitte auf, so daß die koaxialen Entfernungen der weiter außen liegenden Windungslagen zunehmend größer werden, wodurch die resultierenden Abstände der in radialer Richtung ebenfalls zunehmenden Potentialdifferenz angepaßt sind. Der Stabkern 15 ist in der mittleren Zone mit einer aus einem Isoliermaterial bestehenden Trägerplatte 17 aufgehängt, die wenigstens eine Bohrung 17' aufweist. Hochspannungselektroden 18 schirmen die Wicklungen 16 ab. Die Tragkonstruktion der Stabkerndrossel 29 besteht aus Abstützplatten 20, die mit Hilfe eines Zentralbolzens 23 mit Muttern zusammengehalten werden. Die Trägerplatte 17 ist in einem Stützzylinder 21 gelagert. Anschlüsse der Wicklungen 16 sind mit der Bezugsziffer 22 bezeichnet. Der Stützzylinder 21 ist in einer elektrisch isolierenden Tragkonstruktion 24 auf beiden Enden gelagert. Eine Kunststoffscheibe 25 weist eine Bohrung 25' auf und ist in der Tragkonstruktion 24 befestigt. Diese Tragkonstruktion 24 trägt auch eine Membrane 26. Oberhalb dieser Tragkonstruktion 24 befindet sich eine Trennplatte 27, die eine ringförmige Hochspannungselektrode 28 trägt, welche derart ausgebildet ist, daß das magnetische Streufeld der Drossel keine großen Wirbelstromverluste verursacht (vgl. Fig. 7). Ein Ölraum der Stabkerndrossel 29 ist mit der Bezugsziffer 30 bezeichnet.

Die Hochspannungselektroden 18, 28 sowie die Kunststoffscheibe 25 sind aus handelsüblichem, metallisiertem Transformerboard (Firma H. Weidmann AG, CH-8640 Rapperswil) gefertigt. Die Abstützplatten 20 stehen über galvanische Verbindungen 22b mit den jeweils anliegenden Hochspannungselektroden 18 in Kontakt.

Durch den offenen Magnetkreis konnte das Verhältnis Masse zu Leistung enorm reduziert werden. Auf Grund der gewählten konstruktiven Anordnung wurde eine gleichmäßige Verteilung der elektrischen Feldstärke erzielt, so daß ein sehr gedrängter Aufbau möglich wurde. Im weiteren wurde durch die Aufhängung der Drosseln im Massenschwerpunkt ein sehr geräuschärmer Betrieb möglich, da keine Magnetkräfte (Magnetstriktionen etc.) auf das Gehäuse direkt übertragen werden. Die Aufhängevorrichtung ist als Isolierplatte ausgebildet und ergibt gleichzeitig eine Potentialtrennung zwischen beiden Spulen, zudem wirkt sie als Dämpfungsglied für mechanische Schwingungen.

Der symmetrische Aufbau der Drossel ergibt eine induktive Spannungsverteilung, welche gleich der kapazitiven Spannungsverteilung ist, dadurch ergibt sich eine extrem hohe Stoß-Spannungsfestigkeit der Drossel, was insbesondere im Falle des Durchschlagens eines Prüflings zur Verhinderung von Isolationsfehlern in der Drossel notwendig ist.

Bei einer realisierten Stabkerndrossel mit einem Stabkern 15 von 200 mm Durchmesser und 440 mm Länge sowie einem äußeren Durchmesser der Wicklungen 16 von ca. 400 mm wurde eine Nennimpedanz $L_N$ von 51,5 H gemessen.

Damit konnte — in Übereinstimmung mit den vorstehenden Gleichungen — ein Prüfling mit einer Kapazität $C_N = 46$ nF bei einer Prüffrequenz f von 103 Hz, bei einer Prüfspannung von 200 kV und einer Strombelastung von 6 A während der erforderlichen Prüfdauer von 10 Min. einwandfrei getestet werden. Realisiert wurde ein Verhältnis Masse zu Leistung von 0,25 kg pro kVA Drosselleistung bei $f_N$ (103 Hz) bzw. 0,5 kg pro kVA bei 50 Hz; Kurzzeitbetrieb von 15 Minuten.

Durch eine beispielsweise kaskadenförmige Serienschaltung von 4 Drosseln läßt sich eine Prüfspannung von 800 kV erzielen (bei $f_N = 103$ Hz und $C_N = 11,5$ nF).

Das Baukastenprinzip der Anordnung der Stabkerndrosseln ist aus Fig. 8 näher ersichtlich:

Auf einer Tragkonstruktion 24 befinden sich drei gleichartige ineinandergestellte Stabkerndrosseln 29, 29' und 29", welche je endseitig durch eine Hochspannungselektrode 28 bis 28'" galvanisch mit der zugehörigen Wicklung 16 verbunden sind. Schematisch eingezeichnet ist ebenfalls die Verteilung des elektrischen Feldes mit ihren Äquipotentialflächen. Die gestrichelt charakterisierten Äquipotentiallinien sind in Potentialdifferenzen von je 50 kV aufgezeigt: $Ae_1 = 50$ kV; $Ae_2 = 100$ kV = Potential des mit der galvanischen Verbindung 22a (vgl. Fig. 7) in Kontakt stehenden Eisenkerns; $Ae_3 = 150$ kV etc. Die Hochspannungselektrode 28 weist dementsprechend ebenfalls Nullpotential auf, während 28' sich auf einem elektrischen Potential von 200 kV, 28" auf 400 kV und 28'" auf 600 kV befinden. Sämtliche Potentialangaben sind Effektivwerte; die Anordnung weist eine gesamte Bauhöhe von ca. 2'700 mm auf.

Das bei erfindungsgemäß realisierten Drosseln erzielte Verhältnis von Masse zu Leistung ist vergleichsweise ca. 30mal geringer als bei einem Prüftransformator und ca. 10mal geringer als bei einer für eine feste Frequenz ausgelegte Serienresonanzanlage.

Die vorstehend beschriebene Hochspannungsprüfanlage kann den Erfordernissen der Praxis weitgehendst angepaßt werden, so können beispielsweise bei Bedarf problemlos im Serienresonanzkreis HF-Filter integriert werden, z. B. um auch in bekannter Weise Teilentladungsmessungen durchzuführen.

Die im Ausführungsbeispiel ölgekapselten Drosseln können auch SF$_6$-gekapselt sein, was insbesondere bei mobilen Prüfeinrichtungen zur Hochspannungsprüfung von SF$_6$-Schaltanlagen vorteilhaft wäre. Hierbei könnte das am Ort der Prüfung zur Verfügung stehende Isolierglas auch für die Isolierung und Kühlung der Drosseln in der Prüfanlage mitverwendet werden.

**Patentansprüche**

1. Hochspannungsprüfanlage mit einem Serienresonanzkreis, gebildet aus einer Kapazität und einer Induktivität, zur Prüfung einer elektrischen Isolation, dadurch gekennzeichnet, daß der Serienresonanzkreis (4, 5) an eine Spannungsquelle (2) mit einer zumindest annähernd stufenlos veränderlichen Frequenz angeschlossen ist.

2. Hochspannungsprüfanlage nach Anspruch 1, dadurch gekennzeichnet, daß die Induktivität (4) wenigstens im wesentlichen konstante Induktivitätswerte aufweist.

3. Hochspannungsprüfanlage nach Anspruch 1, dadurch gekennzeichnet, daß die Induktivität (4) aus einer Serien- und/oder Parallelschaltung von wenigstens zwei Hochspannungsdrosseln (4a bis 4d) mit wenigstens im wesentlichen konstanten Induktivitätswerten besteht.

4. Hochspannungsprüfanlage nach Anspruch 3, dadurch gekennzeichnet, daß die Hochspannungsdrosseln (4a bis 4d) als Baukastenelemente ausgebildet sind.

5. Hochspannungsprüfanlage nach Anspruch 1, dadurch gekennzeichnet, daß wenigstens eine Induktivität (4) in der Form einer Stabkerndrossel (29) aufgebaut ist.

6. Hochspannungsprüfanlage nach Anspruch 1, dadurch gekennzeichnet, daß die Spannungsquelle (2) mit veränderlicher Frequenz aus einem Umrichter besteht, an den ein Transformator (3) angeschlossen ist.

7. Hochspannungsprüfanlage nach Anspruch 6, dadurch gekennzeichnet, daß der Umrichter (2) ein als Schwingkreisumrichter ausgebildeter Direktumrichter ist, der mit der Resonanzfrequenz des Serienresonanzkreises (4, 5) betrieben wird und durch eine Impulsbreitensteuerung die Höhe der Spannung am Serienresonanzkreis stufenlos verändert.

8. Hochspannungsprüfanlage nach Anspruch 1, dadurch gekennzeichnet, daß parallel zur Isolation (5') wenigstens ein Hochspannungskondensator (5") zur Einstellung einer gewünschten Frequenz angeschlossen ist.

9. Hochspannungsprüfanlage nach Anspruch 1, dadurch gekennzeichnet, daß diese als eine Vorrichtung mit einer Steuerung der Phasenverschiebung von Strom und Spannung am Ausgang des Umrichters (2) ausgeführt ist.

10. Hochspannungsprüfanlage nach Anspruch 5, dadurch gekennzeichnet, daß die Stabkerndrossel (29) im Massenschwerpunkt aufgehängt ist.

11. Hochspannungsprüfanlage nach Anspruch 10, dadurch gekennzeichnet, daß die Aufhängung als eine aus einem Isoliermaterial bestehende Trägerplatte (17) ausgeführt ist.

12. Hochspannungsprüfanlage nach Anspruch 5, dadurch gekennzeichnet, daß die Stabkerndrossel (29) mit zwei in axialer Richtung getrennt angeordneten Wicklungen (16) ausgeführt ist.

13. Hochspannungsprüfanlage nach Anspruch 5, dadurch gekennzeichnet, daß die Stabkerndrossel (29) in einem mit flüssigem oder gasförmigem Isolierstoff gefüllten Raum gelagert ist, der mit einer Tragkonstruktion (24), einem Stützzylinder (21) und wenigstens einer Membrane (26) abgeschlossen ist.

14. Hochspannungsprüfanlage nach Anspruch 5, dadurch gekennzeichnet, daß die Wicklungen (16) der Stabkerndrossel (29) trapezförmige Querschnitte aufweisen, wobei sich die breiteren Teile der trapezförmigen Querschnitte auf den kleineren Durchmesser befinden als die dazu koaxialen schmäleren Teile.

15. Hochspannungsprüfanlage nach den Ansprüchen 12 und 14, dadurch gekennzeichnet, daß die trapezförmigen, getrennten Wicklungen (16) der Stabkerndrossel (29) im Bereich des kleinsten Durchmessers galvanisch mit dem Stabkern (15) verbunden sind.

16. Hochspannungsprüfanlage nach Anspruch 12 und/oder 14, dadurch gekennzeichnet, daß der Eisenkern der Stabkerndrossel (29) wenigstens einen Luftspalt im Bereich seiner Längsabmessung aufweist.

## Claims

1. A high-voltage testing system with a series resonant circuit formed by a capacitor and an inductor for the purpose of testing electrical insulation, wherein said series resonant circuit (4, 5) is connected to a voltage supply (2) whose frequency is at least approximately continuously variable.

2. A high-voltage testing system according to Claim 1, wherein said inductor (4) has at least essentially constant inductance values.

3. A high-voltage testing system according to Claim 1, wherein said inductor (4) consists of a series and/or parallel connection of at least two high-voltage chokes (4a to 4d) having at least essentially constant inductance values.

4. A high-voltage testing system according to Claim 3, wherein said high voltage chokes (4a to 4d) are designed as modular elements.

5. A high-voltage testing system according to Claim 1, wherein at least one inductor (4) is designed in the form of a bar-core choke (29).

6. A high-voltage testing system according to Claim 1, wherein said variable frequency voltage supply (2) consists of a frequency converter to which a transformer (3) is connected thereto.

7. A high-voltage testing system according to Claim 6, wherein said converter (2) is a direct frequency converter of the oscillating circuit type, which is driven at the resonance frequency of the resonant circuit (4, 5) and which is able to vary continuously the voltage at the resonant circuit by means of a pulse-width control.

8. A high-voltage testing system according to Claim 1, wherein at least one high-voltage capacitor (5″) is connected in parallel with said electrical insulation (5′) for the adjustment of a desired frequency.

9. A high-voltage testing system according to Claim 1, wherein said system is designed as a device having a control of the phase shift between the current and voltage at the output of the converter (2).

10. A high-voltage testing system according to Claim 5, wherein said bar-core choke (29) is suspended at the center of gravity.

11. A high-voltage testing system according to Claim 10, wherein the suspension is provided by a mounting plate (17) made from an insulating material.

12. A high-voltage testing system according to Claim 5, wherein said bar-core choke (29) is provided with two windings (16) which are arranged separately in the axial direction.

13. A high-voltage testing system according to Claim 5, wherein said bar-core choke (29) is located in a space filled with a liquid or gaseous insulating material; said space being closed by a bearing construction (24), a support cylinder (21) and at least one membrane (26).

14. A high-voltage testing system according to Claim 5, wherein the windings (16) of the bar-core choke (29) have trapezoidal cross sections, with the wider portions of the trapezoidal cross section corresponding to the inner windings and the narrower portions corresponding to the outer windings.

15. A high-voltage testing system according to Claim 12 and 14, wherein the separated trapezoidal windings (16) of the bar-core choke (29) are in galvanic connection with the bar-core (15) in the area of the smallest diameter.

16. A high-voltage testing system according to Claim 12 and/or 14, wherein the iron core of said bar-core choke (29) has at least one air gap in the area of its longitudinal dimension.

## Revendications

1. Installation d'essai ou d'épreuve à haute tension comprenant un circuit résonant en série, formé par une capacité et une inductance, pour l'épreuve d'une isolation électrique, caractérisée en ce que le circuit résonant en série (4, 5) est relié à une source de tension (2) ayant une fréquence variable au moins approximativement sans palier.

2. Installation d'épreuve haute tension selon la revendication 1, caractérisée en ce que l'inductance (4) a des valeurs d'inductance au moins sensiblement constantes.

3. Installation d'épreuve haute tension selon la revendication 1, caractérisée en ce que l'inductance (4) est formée par un montage en série et/ou en parallèle d'au moins deux selfs haute tension (4a à 4d) à valeurs d'inductance au moins sensiblement constantes.

4. Installation d'épreuve haute tension selon la revendication 3, caractérisée en ce que les selfs haute tension (4a à 4d) sont réalisées sous forme d'éléments modulaires.

5. Installation d'épreuve haute tension selon la revendication 1, caractérisée en ce qu'au moins une inductance (4) est réalisée sous forme d'une self (29) à noyau en forme de barre.

6. Installation d'épreuve haute tension selon la revendication 1, caractérisée en ce que la source de tension (2) à fréquence variable consiste en un convertisseur auquel est raccordé un transformateur (3).

7. Installation d'épreuve haute tension selon la revendication 6, caractérisée en ce que le convertisseur (2) est un convertisseur direct réalisé sous forme de convertisseur de circuit oscillant, qui est excité par la fréquence de résonance du circuit résonant en série (4, 5), et en ce que la valeur de la tension au circuit résonant en série varie de manière progressive sous l'action d'une commande de la largeur d'impulsion.

8. Installation d'épreuve haute tension selon la revendication 1, caractérisée en ce qu'au moins un condensateur haute tension (5″) est monté en parallèle à l'isolation (5′) pour l'établissement d'une fréquence souhaitée.

9. Installation d'épreuve haute tension selon la revendication 1, caractérisée en ce qu'elle est réalisée en tant que dispositif avec une commande du décalage de phase de l'intensité et de la tension à la sortie du convertisseur (2).

10. Installation d'épreuve haute tension selon la revendication 5, caractérisée en ce que la self (29) à noyau est suspendue au centre de gravité.

11. Installation d'épreuve haute tension selon la revendication 10, caractérisée en ce que la suspension est réalisée par une plaque-support (17) en matériau isolant.

12. Installation d'épreuve haute tension selon la revendication 5, caractérisée en ce que la self (29) à noyau présente deux enroulements (16) disposés séparément en direction axiale.

13. Installation d'épreuve haute tension selon la revendication 5, caractérisée en ce que la self (29) à noyau est montée dans une chambre remplie d'un agent isolant liquide ou gazeux et qui est fermée par une structure de support (24), un cylindre d'appui (21) et au moins une membrane (26).

14. Installation d'épreuve haute tension selon la revendication 5, caractérisée en ce que les enroulements (16) de la self (29) à noyau présentent des sections trapézoïdales, les parties les plus larges des sections trapézoïdales se trouvant sur les plus petits diamètres par rapport aux parties les plus étroites que leur sont coaxiales.

15. Installation d'épreuve haute tension selon les revendications 12 et 14, caractérisée en ce que les enroulements (16) trapézoïdaux séparés de la self (29) à noyau sont reliés galvaniquement au noyau (15) dans la zone du plus petit diamètre.

16. Installation d'épreuve haute tension selon la revendication 12 et/ou la revendication 14, caractérisée en ce que le noyau de fer de la self (29) présente au moins un entrefer dans la zone de sa dimension longitudinale.

FIG.1

FIG.2

FIG.3

FIG. 4

FIG. 5

FIG. 6

FIG.7

FIG. 8